# EUROPEAN PATENT SPECIFICATION

(11) **EP 2 498 258 B1**
(45) Date of publication and mention of the grant of the patent: **13.01.2016**
(21) Application number: 11191484.2
(22) Date of filing: 01.12.2011
(51) Int. Cl.: G11C 16/10

(54) **Non-volatile memory device with program current clamp and related method**
Nichtflüchtige Speichervorrichtung mit Programmierstrombegrenzung und zugehöriges Verfahren
Dispositif à mémoire non volatile avec fixation de courant de programmation et procédé correspondant

(30) Priority: 11.03.2011 US 451605 P
(43) Date of publication of application: 12.09.2012
(73) Proprietor: eMemory Technology Inc., Hsin-Chu 30075 (TW)
(72) Inventor: Fang, Shang-Wei, Yilan County 260 (TW); Chen, Ying-Je, Taichung City 408 (TW); Liao, Hong-Yi, Hsinchu City 300 (TW); Sun, Wein-Town, Taoyuan County 325 (TW); Tsai, Yu-Hsiung, Hsinchu City 300 (TW); Liu, Cheng-Jye, Hsinchu County 302 (TW)
(74) Representative: Becker Kurig Straus

(56) References cited:
- WO-A1-2004/072981
- US-A1- 2009 219 762
- US-B1- 6 219 279

## Description

### Field of the Invention

The present invention relates to non-volatile memory devices, and more particularly to a non-volatile memory device and related method that use a program current clamp.

### Background of the Invention

Non-volatile memory is a type of memory that retains information even when no power is supplied to memory blocks thereof. Some examples include magnetic devices, optical discs, flash memory, and other semiconductor-based memory topologies. Some forms of non-volatile memory have bits defined in fabrication, some may be programmed only once (one time programmable ROM, OTP ROM), and other types may be programmed and reprogrammed many times over. As semiconductor memory technologies are scaled down, memory cell programming and reading times have decreased (making memory cells faster), require less current/power to operate, and have improved reliability. Further, program bias voltage decreases in advanced technology.

Memory cells are typically programmed through CHEI. CHEI occurs when channel carriers traveling from source to drain of a metal-oxide-semiconductor (MOS) transistor are heated due to drain-source voltage applied across the drain and the source. The hot electrons at the end of the channel have high energy, and are injected into a floating gate of the MOS transistor approximately in a direction perpendicular to the floating gate. However, a corner effect causes multiple issues when using CHEI to program, including longer programming time, wider array distribution, higher power consumption, and poor reliability due to hole damage. To compensate for the corner effect, circuit design becomes more complex and requires larger area.

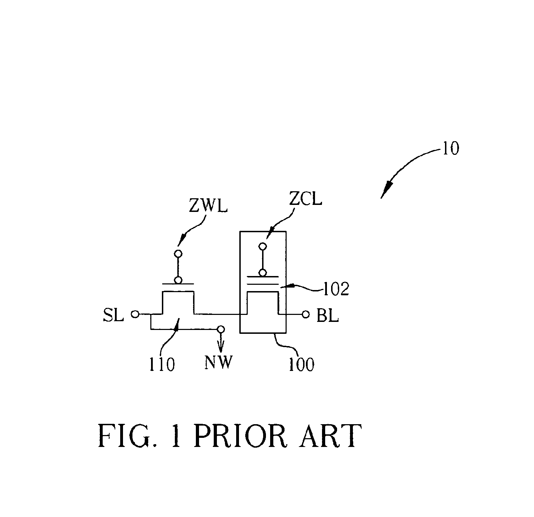

Please refer to FIG. 1, which is a diagram illustrating a memory cell 10 comprising a memory transistor 100 and a select transistor 110 according to the prior art. As shown in FIG. 1, a control line voltage ZCL is connected to the gate of the memory transistor 100, and a bit line voltage BL is connected to the drain of the memory transistor 100. Moreover, a word line voltage ZWL is connected to the gate of the select transistor 110 and a source line voltage SL is connected to the source of the select transistor 110. The source line and the n well NW are at a common voltage level (VSL=VNW).

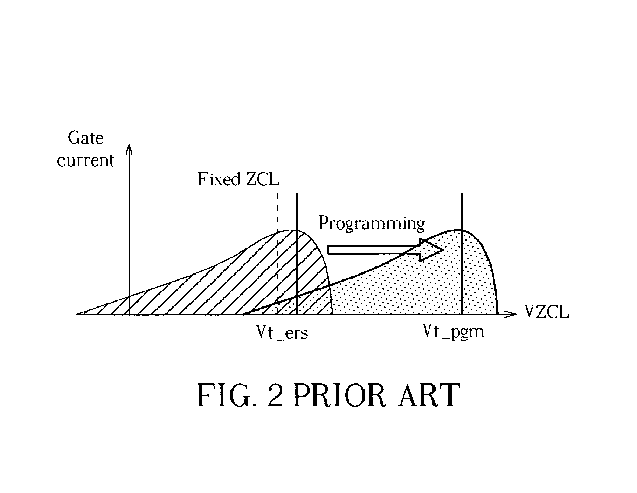

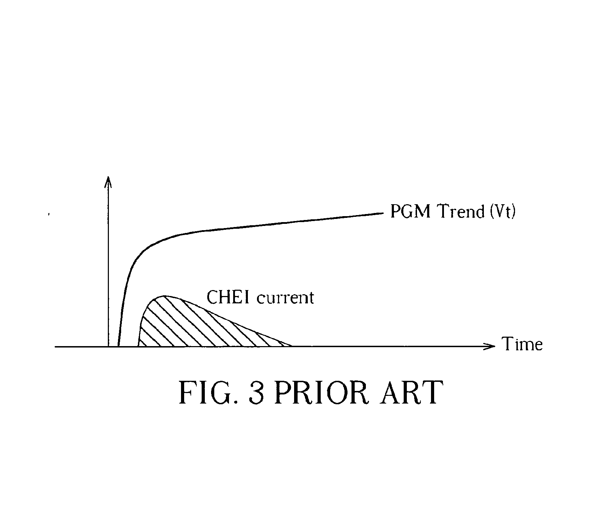

Please refer to FIG. 2 and FIG. 3, which are a diagram illustrating gate current versus gate voltage for a fixed control line voltage ZCL, and a diagram illustrating threshold voltage and CHEI current versus time for the fixed control line voltage, respectively. At an initial programming voltage Vt_ers corresponding to the memory transistor 100 being in an erased state, gate current obtained by applying the control line voltage ZCL is higher near the initial programming voltage Vt_ers, and lower the further away the control line voltage ZCL is from the initial programming voltage Vt_ers. However, during programming, threshold voltage Vt of the memory transistor 100 may shift. Thus, when the control line voltage ZCL applied during programming is fixed, a channel hot electron injection (CHEI) current profile obtained over time approximates that shown in FIG. 3 (convolution of the two areas shown in FIG. 2). As shown in FIG. 3, CHEI current is initially high and threshold voltage Vt of the memory transistor 100 increases rapidly. However, as the threshold voltage Vt increases, the CHEI current tapers off, and increase of the threshold voltage Vt slows down. This behavior leads to slow, inefficient programming of the memory transistor 100.

International Publication WO 2004/072981 discloses a nonvolatile memory cell which applies a ramped gate voltage when cells fail a verification process. A current limit is applied for preventing the programming current from rising too high. The current limit must be turned off for hard to program cells, resulting in potential damage to the memory cell and poor efficiency.

U.S. Publication 2009/0219762 also discloses a ramped gate voltage, so that hot electrons with sufficient energy levels can be generated in order to maintain an amount of electron which can he injected. The programming voltage wilt be ramped for each program-verify operation until all memory cells pass a verification process. U.S. Patent 6.219.279 disclosed a method of hot electron injection including a programming driver for limiting a programming current. The current limit is chosen according to the size of the driving transistors, and mirroring a current in the two driving transistors.

### Summary of the Invention

This in mind. the present invention aims at providing a non-volatile memory device that provides efficient programming of a memory transistor.

This is achieved by a method and a non-volatile memory device according to claims 1 and 6. The dependent claims pertain to corresponding further developments and improvements.

According to an embodiment, a method of programming a nonvolatile memory cell which comprises a select transistor and a memory transistor comprises applying a bias voltage to a first input of the memory cell, applying a preset limit current to a current limiting circuit electrically connected to a second input of the memory cell, and applying a ramped gate voltage to the memory cell to program the memory cell with a preset limited current determined by the current limiting circuit according to the limit voltage.

According to an embodiment, a nonvolatile memory device comprises a select transistor, a memory transistor, and a current limiting circuit. The select transistor has a first terminal, second terminal, and a gate terminal. The memory transistor has a third terminal coupled to the second terminal of the select transistor, a fourth terminal, and a control terminal. The control terminal of the memory transistor receives a ramped gate voltage for inducing a program current to program the memory transistor. The current limiting circuit controls bias across the first terminal of the select transistor and the fourth terminal of the memory transistor for limiting the program current.

As will be seen more clearly from the detailed description following below, the claimed non-volatile memory device includes a program current clamp that has a select transistor, a memory transistor, and a current limiting circuit for controlling a voltage drop across the first terminal of the select transistor and the fourth terminal of the memory transistor for limiting the program current.

### Brief Description of the Drawings

In the following, the invention is further illustrated by way of example, taking reference to the accompanying drawings. Thereof
FIG 1 is a diagram illustrating a memory cell according to the prior art;
FIG 2 is a diagram illustrating gate current versus gate voltage for a fixed control line voltage;
FIG 3 is a diagram illustrating threshold voltage and CHEI current versus time for the fixed control line voltage;
FIG 4 is a diagram illustrating gate current and drain current as a function of gate voltage applied to a memory cell;
FIG 5 is a diagram illustrating gate current versus gate voltage for a ramped control line voltage;
FIG 6 is a diagram illustrating threshold voltage and CHEI current versus time for the ramped control line voltage;
FIG 7 is a timing diagram of control line signal and source line voltage signal.
FIG. 8 is a timing diagram of control line signal and source line voltage signal;
FIG. 9 is a timing diagram illustrating programming of a fast corner memory cell with verify-while-programming (VWP);
FIG. 10 is a timing diagram illustrating programming of a slow corner memory cell with VWP;
FIG. 11 is a flow chart of a process for performing channel hot electron injection programming with VWP;
FIG. 12 is a diagram illustrating ramping of gate voltage;
FIG. 13 is a diagram illustrating ramping of gate voltage;
FIG. 14 is a diagram illustrating ramping of gate voltage;
FIG. 15 is a diagram illustrating ramping gate voltage and source line/n-well voltages;
FIG. 16 is a diagram illustrating ramping gate voltage and source line/n-well voltages;
FIG. 17 is a diagram of a nonvolatile memory device for reducing programming current and improving reliability;
FIG. 18 is a diagram illustrating a double gate transistor;
FIG. 19 is a diagram of the memory cell of FIG. 1 coupled to a program current limiting circuit according to an embodiment;
FIG. 20 is a diagram of one configuration of the program current limiting circuit of FIG. 19; and
FIG. 21 is a flowchart of a method for programming a memory cell.

### Detailed Description

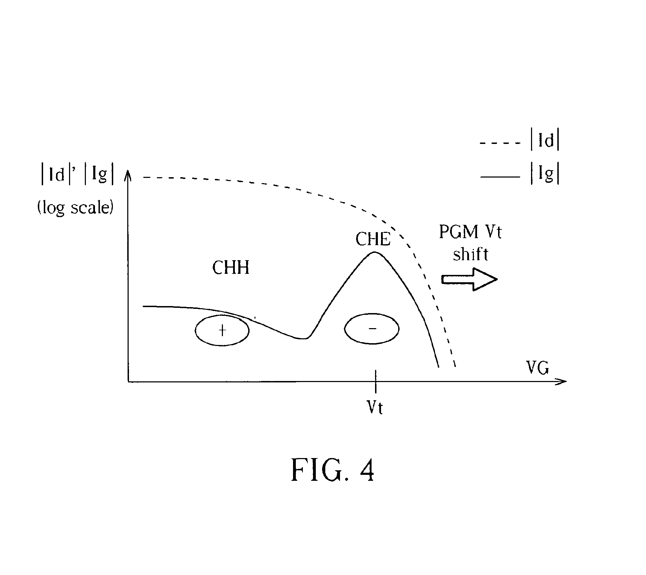

Please refer to FIG. 4, which illustrates gate current |Ig| and drain current |Id| as a function of gate voltage VG applied to a memory cell. The gate voltage VG may be a control line voltage applied through a control line to a control line input, such as a gate, of the memory transistor 100. Assuming the memory transistor 100 has an initial threshold voltage Vt, as gate voltage VG (signal ZCL) applied to a gate of the memory transistor 100 approaches the threshold voltage Vt, channel hot electron (CHE) injection occurs, and gate current |Ig| is maximized. Below the threshold voltage Vt, gate voltage VG results in lower gate current |Ig|, eventually leading to channel hot hole (CHH) injection, which may damage the memory transistor 100. Above the threshold voltage Vt, gate voltage VG results in diminishing gate current |Ig|, and drain current |Id| also drops off. As shown in FIG 4, during programming, threshold voltage Vt increases as electrons are injected into a floating gate or ONO layer 102 of the memory transistor 100. Knowing this threshold voltage Vt shift phenomenon, by programming at a slightly increased gate voltage VG e.g. 0.5 Volts over threshold voltage Vt, gate current |Ig| may be kept at a higher level for a greater proportion of the programming cycle, leading to faster programming time, and risk of dropping into CHH injection may also be reduced. Chip area may be reduced as conduction current is relatively low.

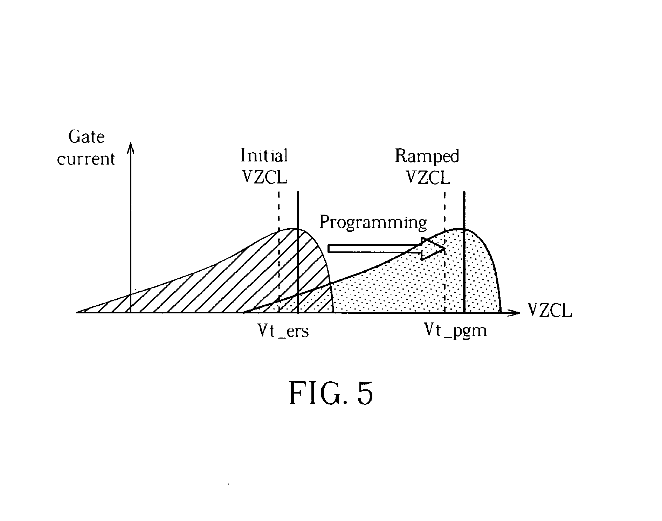

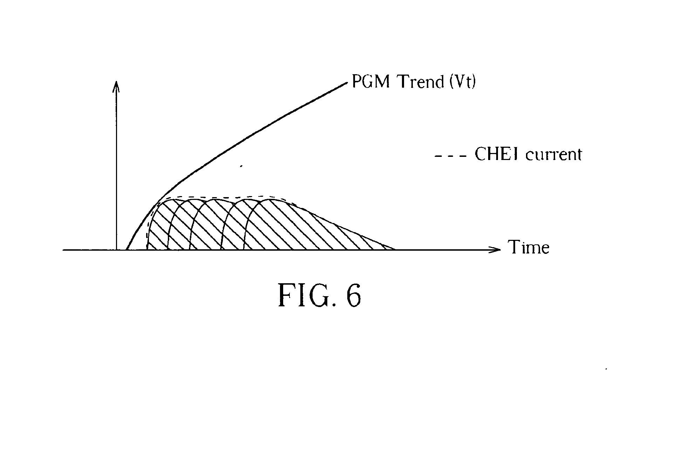

Please refer to FIG 5 and FIG 6, which are diagrams illustrating gate current versus gate voltage (FIG 5) and threshold voltage and CHEI current versus time (FIG 6) for a ramped control line voltage programming method according to an embodiment. In a preferred mode, gate voltage VG applied to the memory transistor 100 during programming increases with threshold voltage shift. As shown in FIG 5, initial gate voltage (left dashed line) is applied to maximize gate current (left hump peaks near initial gate voltage). As programming progresses, threshold voltage of the memory transistor 100 increases, such that initial gate voltage may be lower than erase voltage Vt_ers (left solid line). Simultaneously, threshold voltage of the memory transistor 100 is already at a higher voltage Vt_pgm. Thus, by ramping gate voltage applied to the memory transistor 100 with increasing threshold voltage (right hump peaks near Vt_pgm); the memory transistor 100 may be programmed by gate injection current at a predetermined level, e.g. roughly maximum gate current. Stepped ramping of gate voltage is shown conceptually in FIG 6, where CHEI current is kept roughly maximum throughout programming, leading to rapid increase of threshold voltage Vt over time.

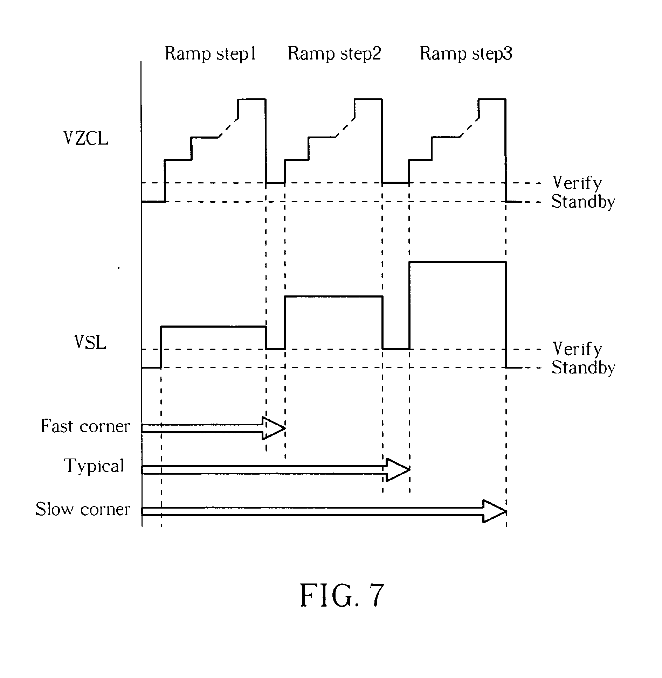

Please refer to FIG 7, which is a timing diagram of control line signal (VZCL) and source line voltage signal VSL according to an embodiment. As shown in FIG 7, control line signal VZCL applied to gate of the memory transistor 100 is ramped, and source line voltage signal VSL applied to source line may also be ramped. Ramping the source line voltage signal VSL increases source line (SL) to bit line (BL) bias (BL voltage =0 volt), which also leads to better programming results. In FIG. 7, each increase in SL to BL bias corresponds to a ramp of control line signal VZCL. Number of steps in the ramp of control line signal VZCL is not limited herein, and is preferably at least one. Following each ramp of control line signal VZCL, a verification process is performed. Once verification is finished, if verification fails, further programming is required, so SL to BL bias is increased, and ramp of control line signal VZCL restarts. If verification passes, the control line signal VZCL and the source line voltage signal VSL may each enter a standby mode to stop programming. As shown in FIG. 7, three cycles may be employed to cover fast corner, typical, and slow corner memory cells. Fast corner memory cells pass verification after one programming ramp, typical memory cells pass verification after two programming ramps, and slow corner memory cells may pass verification after three programming ramps.

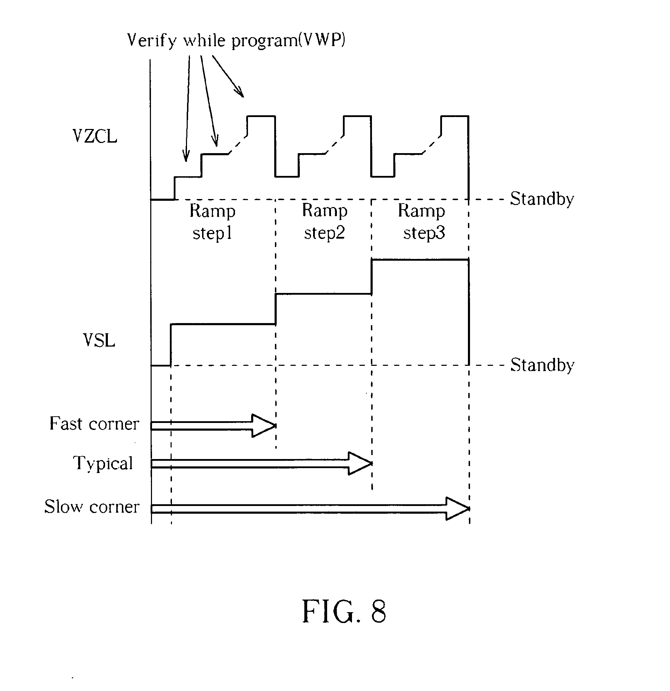

Please refer to FIG. 8, which is a timing diagram of control line signal (VZCL) and source line voltage signal VSL. The timing diagram shown in FIG. 8 is similar to the diagram shown in FIG. 7, except that verification is performed during programming (Verify While Program, VWP). Thus, when one ramp of control line signal VZCL is finished, a new ramp of control line signal VZCL begins immediately thereafter, without a pause for verification.

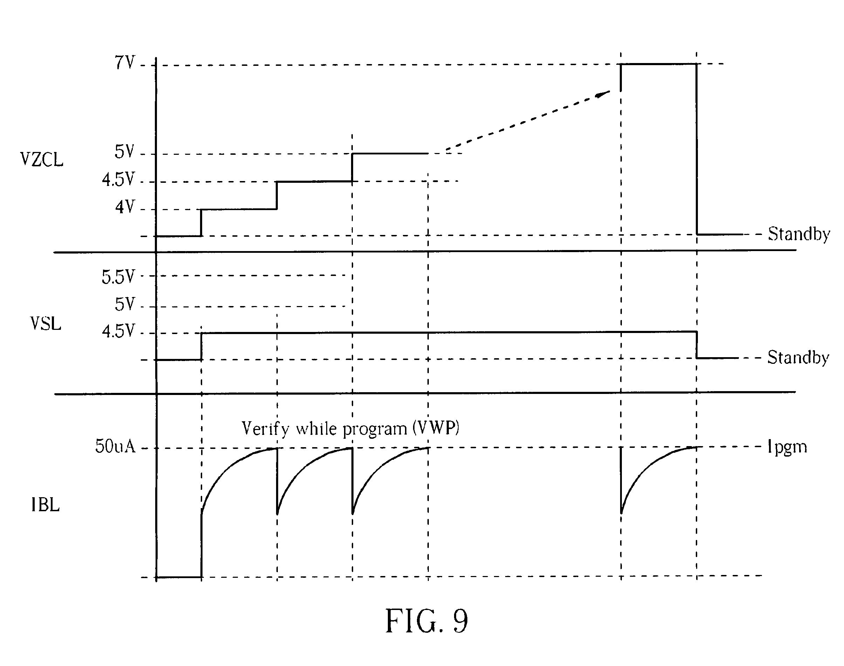

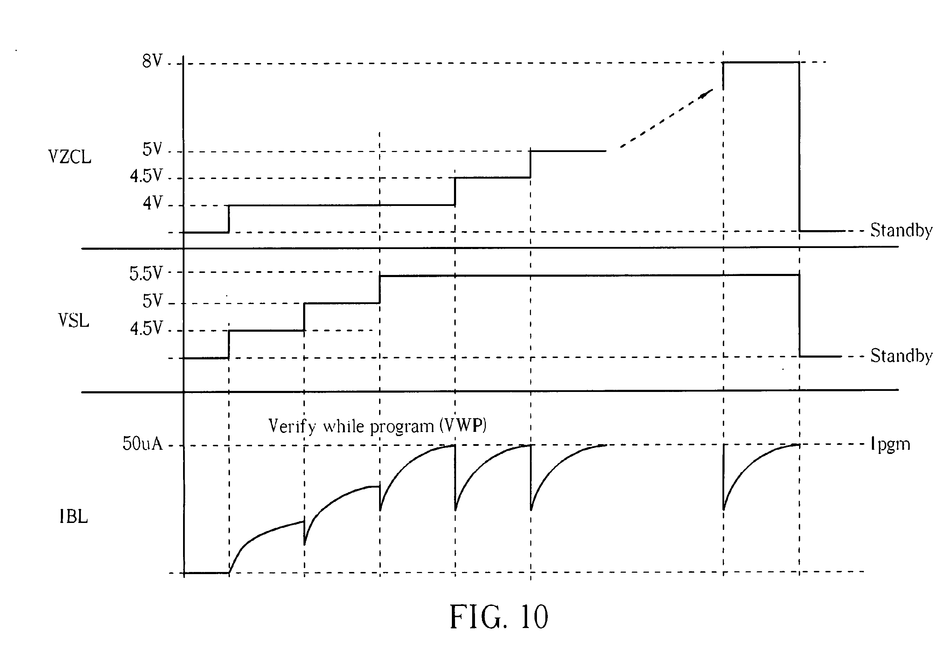

Please refer to FIG. 9 and FIG. 10. FIG. 9 is a timing diagram illustrating programming of a fast corner memory cell with VWP. FIG. 10 is a timing diagram illustrating programming of a slow corner memory cell with VWP. Voltages and times shown in FIG. 9 and FIG. 10 are provided as an example. To achieve high speed and low power consumption, control line signal VZCL is ramped. Start bias of control line signal VZCL may be close to initial threshold voltage Vt_start, and final bias may determine final programming threshold voltage Vt_final. To overcome device variation and disturb, SL to BL bias is ramped by ramping source line voltage signal VSL. For a fast corner memory cell (FIG. 9), one ramp of control line signal VZCL may be sufficient to complete programming, such that source line voltage signal VSL is kept constant throughout programming, and is not ramped. For a slow corner memory cell (FIG. 10), source line voltage signal VSL may be ramped until sufficiently high gate current is detected, e.g. 50 micro amps (µA), at which time control line signal VZCL may start to be ramped until programming is

complete. As shown in FIG. 9 and FIG. 10, each step of ramping control line signal VZCL may begin upon reaching programming current Ipgm, e.g. 50 µA; each step of ramping SL to BL bias may begin upon reaching maximum programming time, e.g. 5 microseconds (us), without having reached programming current Ipgm. Please note that maximum programming time may be applied to both ramping source line voltage signal VSL and ramping control line signal VZCL. Maximum programming time may be applied to ramping source line voltage signal VSL, and a ramping programming time may be applied to ramping control line signal VZCL, where ramping programming time is shorter (faster) than maximum programming time.

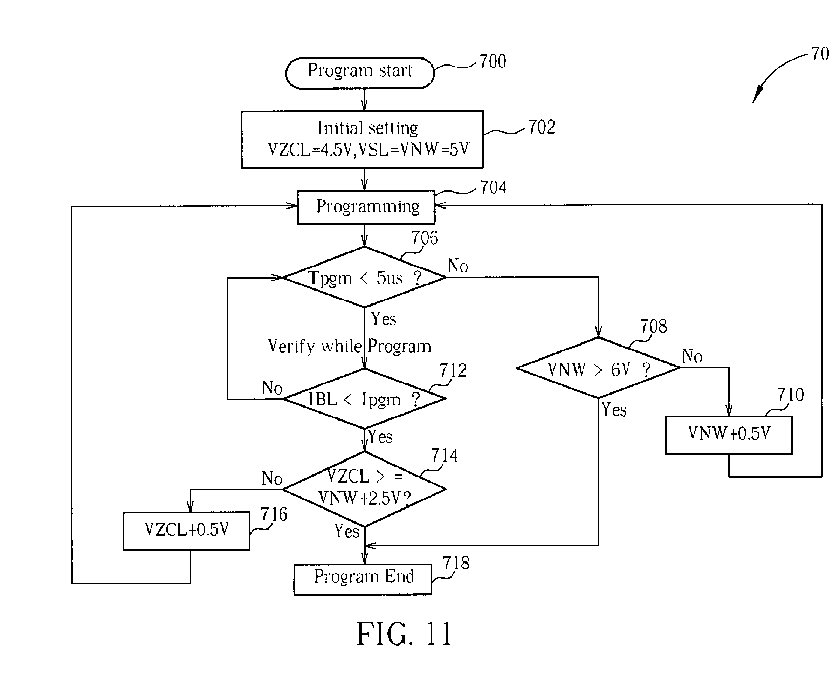

Please refer to FIG. 11, which is a flow chart of a process 70 for performing channel hot electron injection (CHEI) programming with VWP. Programming starts (Step 700) when programming of a memory cell is required. Initial settings are applied to the memory transistor and corresponding select transistor, e.g. VZCL = 4.5 Volts, VSL = VNW = 5V, VBL = 0 Volts, where VNW represents n-well voltage (Step 702). Programming is performed as described above (Step 704). If programming time Tpgm exceeds a predetermined period (Step 706), e.g. 5us, and n-well voltage VNW is lower than a first voltage threshold (Step 708), e.g. 6V, n-well voltage is increased by a first step voltage (Step 710), e.g. 0.5V. If programming time Tpgm exceeds the predetermined period (Step 706), and n-well voltage VNW is higher than the first voltage threshold (Step 708), then programming ends (Step 718), possibly due to a memory cell that is too slow. If programming time Tpgm is less than the predetermined period (Step 706), and bit line current IBL is lower than predetermined programming current Ipgm (Step 712), e.g. 50 µA, the process 70 returns to Step 706. If bit line current IBL exceeds predetermined programming current Ipgm (Step 712) while programming time Tpgm is less than the predetermined period (Step 706), and control line signal VZCL is less than a gate voltage threshold (Step 714), e.g. VNW + 2.5V, control line signal VZCL is increased by a second step voltage (Step 716), e.g. 0.5V. The first step voltage and the second step voltage may be the same or different. If the control line signal VZCL is greater than or equal to the gate threshold voltage, programming ends (Step 718). In the above, the first voltage threshold may be a predetermined control line voltage limit of the control line voltage applied to the control line of the memory transistor 100.

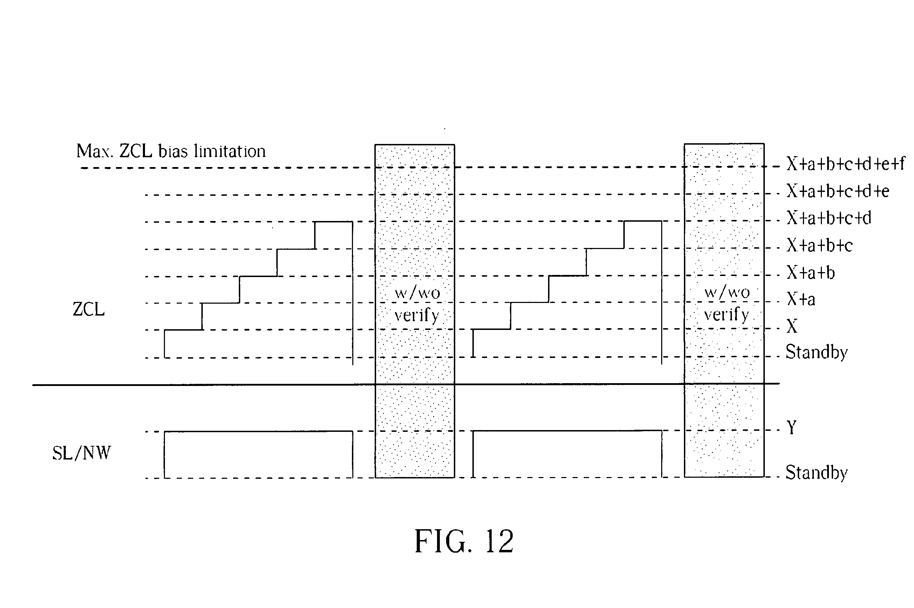

Please refer to FIG. 12, which is a diagram illustrating ramping of gate voltage ZCL. Source line voltage SL, which may roughly equal n-well voltage NW, may be kept constant during programming at a voltage Y. Gate voltage ZCL may be set initially to a voltage X, which is higher than a standby voltage, during programming. A step voltage "a" may be added to the voltage X in a first step, a step voltage "b" may be added to the voltage X+a in a second step, and so forth until a step voltage X+a+b+c+d is reached. Verification may be performed, and a new ramp may begin from the voltage X. A maximum bias limitation may be set for gate voltage ZCL roughly equal to a voltage X+a+b+c+d+e+f. Voltage steps a, b, c, f may be the same or different. Number of voltage steps is also not limited herein.

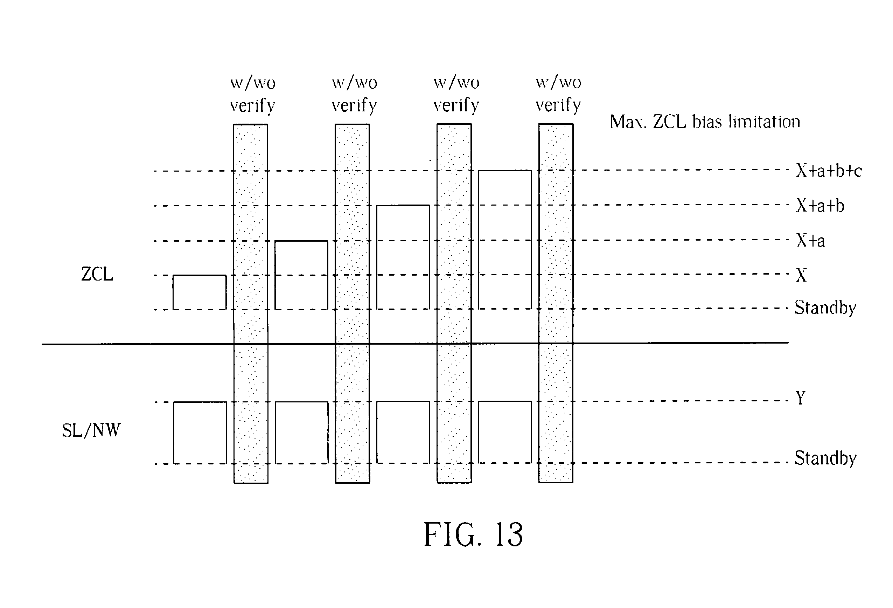

Please refer to FIG. 13, which is a diagram illustrating ramping of gate voltage ZCL. Similar to FIG. 12, only gate voltage ZCL is ramped, and source line voltage SL is kept constant. However, unlike FIG. 12, in FIG. 13, verification may be performed after each step up in gate voltage ZCL. For example, after voltage X is applied, verification may be performed, then voltage X+a may be applied, verification may be performed, and so forth.

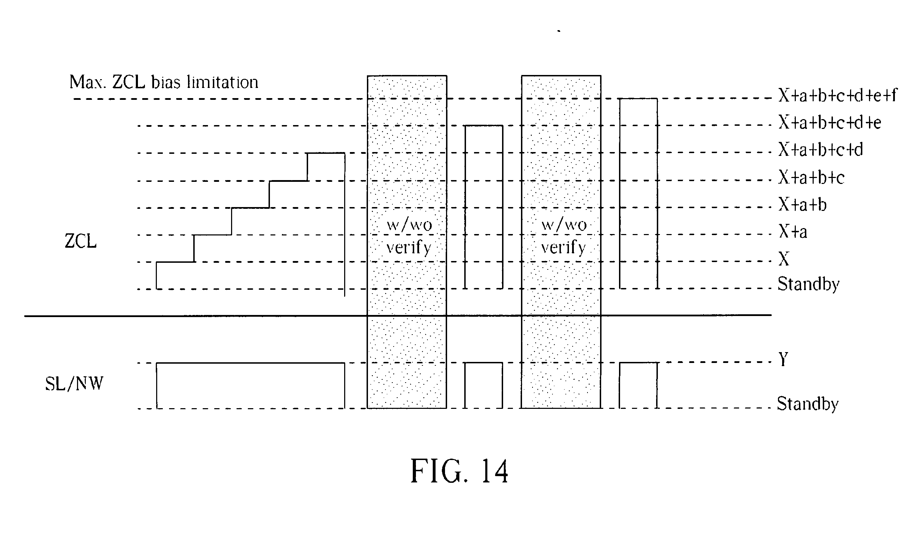

Please refer to FIG. 14, which is a diagram illustrating ramping of gate voltage ZCL. FIG. 14 combines FIG. 12 and FIG. 13. Initially, ramping is performed on gate voltage ZCL uninterrupted, until voltage X+a+b+c+d is reached. Then, verification may be performed before stepping up to voltage X+a+b+c+d+e. Verification may be performed again, then gate voltage ZCL may be stepped up to voltage X+a+b+c+d+e+f. Order of the combination of FIG. 12 and FIG. 13 is not limited to that shown in FIG. 14. FIG. 14 illustrates the ramping of FIG. 12 preceding the ramping of FIG. 13, but the ramping of FIG. 13 may also precede the ramping of FIG. 12.

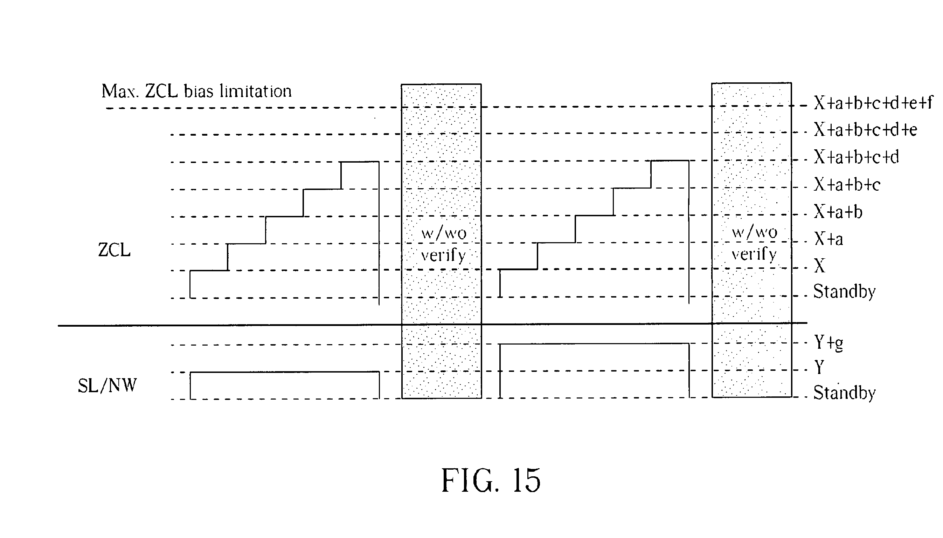

Please refer to FIG. 15, which is a diagram illustrating ramping gate voltage ZCL and source line/n-well voltages SL/NW. Gate voltage ZCL is stepped up from voltage X to voltage X+a+b+c+d, while source line/n-well voltages SL/NW are at voltage Y Verification may be performed. Then, gate voltage ZCL is stepped up again starting from voltage X and increasing to voltage X+a+b+c+d, while source line/n-well voltages SL/NW are at voltage Y+g. Voltage "g" may be the same or different from voltages a, b, ..., f.

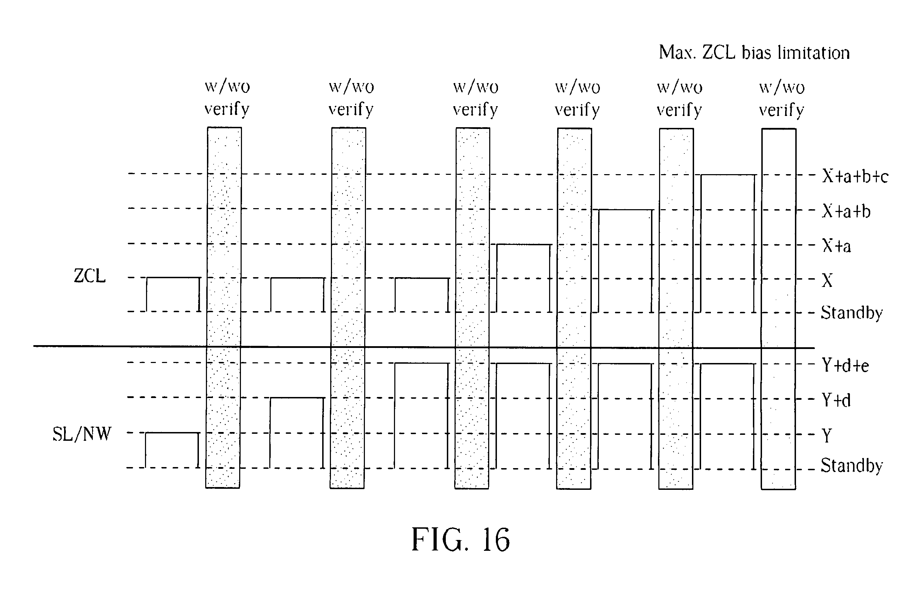

Please refer to FIG. 16, which is a diagram illustrating ramping gate voltage ZCL and source line/n-well voltages SL/NW Initially, source line/n-well voltages SL/NW are stepped up from voltage Y to voltage Y+d, then to voltage Y+d+e. Verification may be performed following each step up in source line/n-well voltages. After reaching voltage Y+d+e, verification may be performed, then gate voltage ZCL may be stepped up from voltage X to voltage X+a, then to voltage X+a+b, then to voltage X+a+b+c, all while source line/n-well voltages SL/NW are at voltage Y+d+e. Verification may be performed after each step up in gate voltage ZCL.

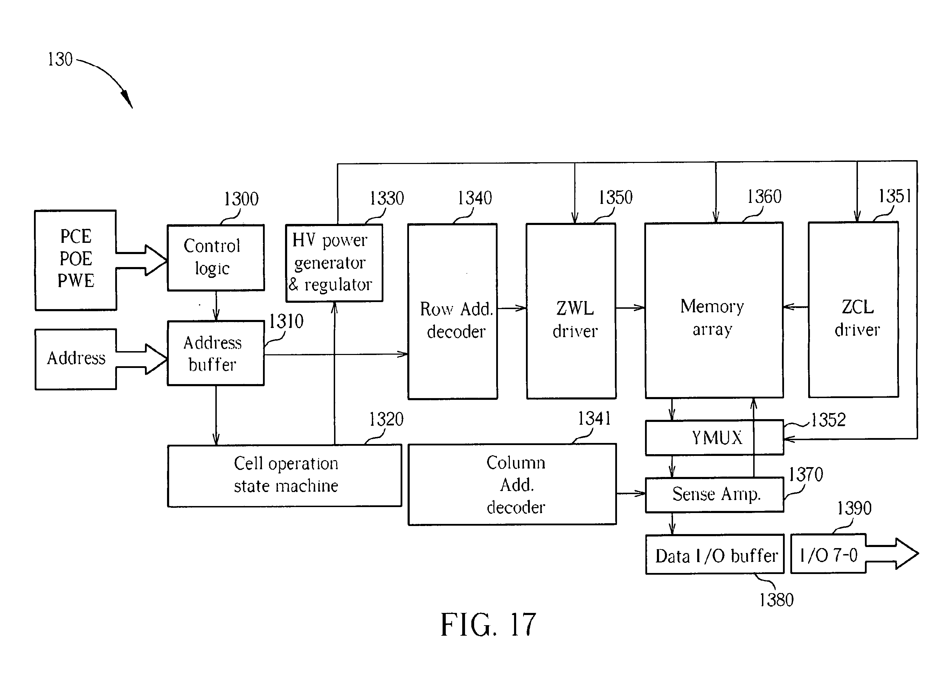

Please refer to FIG. 17, which is a diagram of a nonvolatile memory device 130 for reducing programming current and improving reliability. The nonvolatile memory device 130 comprises a memory cell array 1360, a word line driver 1350 and a control line driver 1351 coupled to the memory cell array 1360, a row address decoder 1340 coupled to the word line driver 1350, an address buffer 1310 coupled to the row address decoder 1340, a multiplexer 1352 coupled to the memory cell array 1360, a power generator 1330 coupled to the memory cell array 1360, the word line driver 1350, the control line driver 1351, and the multiplexer 1352, a sense amplifier 1370 coupled to the multiplexer 1352 and the memory cell array 1360, a column address decoder 1341 coupled to the sense amplifier 1370, a data I/O buffer 1380 coupled to the sense amplifier 1370, an I/O circuit 1390 coupled to the data I/O buffer 1390, and a cell operation state machine 1320 coupled to the address buffer 1310 and the power generator 1330. The memory cell array 1360 comprises memory cells, such as the memory cell 10 of FIG. 1, arranged at crossing points of a bit-line and word-line (or control line) matrix of the memory cell array 1360. The word line driver 1350, the control line driver 1351, the row address decoder 1340, and the column address decoder 1341 form a write circuit for providing multiple variable pulses or constant pulses to each control-line for programming during programming operation. The multiple variable pulses have predetermined amplitude for keeping gate injection current at a predetermined level during programming operation. The predetermined level may be roughly maximum while lowering conduction current. The multiplexer 1352, the sense amplifier 1370, the power generator 1330, and the cell operation state machine 1320 form a verification circuit for sensing variation of conduction current during the programming operation, and disabling the programming operation if the sensed conduction current during the programming operation reaches a predetermined value. The verification circuit may disable the programming operation when a predetermined programming time passes even if the sensed conduction current does not reach the predetermined value. The verification circuit may disable the programming operation when absolute value of the control-line voltage is greater than or equal to absolute value of threshold voltage. In the memory array 1360, each memory cell may be a p-channel memory cell comprising a charge storage layer. The charge storage layer may be an oxide-nitride-oxide (ONO) layer. The multiple variable pulses may further be provided to each bit-line (i.e. SL to BL bias) for programming. A multiple variable pulse pattern of the predetermined amplitude may be a step ramp or independent ramp pattern.

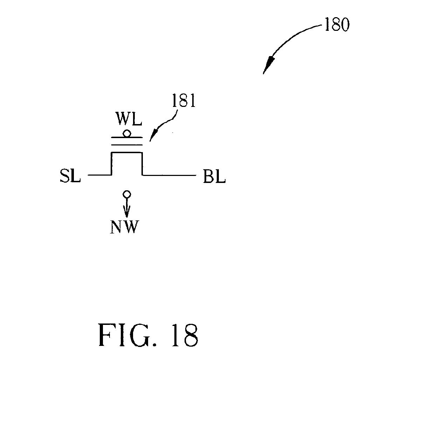

Please refer to FIG. 18, which is a diagram illustrating a double gate transistor 180. The memory cell can also be the double gate transistor 180 comprising the floating gate 181, and may also adopt ramping gate voltage to improve performance. In the above, for the memory cell 10 comprising the two transistors 100, 110, the control line voltage ZCL and/or the select line voltage SL may be ramped. For the double gate transistor 180, word line voltage WL applied to the gate of the double gate transistor 180, and bit line voltage BL applied to the drain of the double gate transistor 180 may be ramped. Ramping of the bit line voltage BL and/or the word line voltage WL shown in FIG. 18 may be accomplished in the same way described above for the control line voltage ZCL and the bit line voltage BL shown in FIG. 1. However, the respective memory cell architectures illustrated in FIG. 1 and FIG. 18 are different, such that connection of the word line voltage WL is different, and the double gate transistor 180 does not take a control line input. For the double gate transistor 180 shown in FIG. 18, for example, word line voltage WL may be ramped after the conduction current reaches a predetermined value and if the memory cell is in the slow corner, bit line voltage BL may also be ramped.

Please note that, although the above description is directed to p-type memory cells, an n-type memory cell may also adopt the same concept. Furthermore, the memory cell in FIG. 18 only represents one example. A single memory transistor containing a charge storage layer may also adopt the same concept.

From the above, it can be seen that ramping the control line voltage ZCL and/or the bit line voltage BL effectively reduces programming time, thereby increasing programming efficiency of the memory cell 10 shown in FIG 1. Likewise, ramping the word line voltage WL and/or the bit line voltage BL effectively reduces programming time, thereby increasing programming efficiency of the double gate transistor 180 shown in FIG 18.

In the above examples, ZCL ramping is used to optimize programming current and increase programming speed. However, if programming current is too high, circuit area must be increased to handle higher currents, which is undesirable from a circuit design perspective. For example, higher programming current increases pumping circuit area. Further, device corner variation requires higher program current prediction, and wastes circuit area. Finally, higher programming current also causes unnecessary damage to the memory cell, which may lead to poor programming efficiency after thousands of cycles. By selecting a slightly lower programming current, the circuit designer may avoid these issues while maintaining most of the speed and operation window advantages afforded by ZCL ramping. In the following description, a current limiting circuit is introduced into the memory cell architecture that acts to limit the programming current while retaining the various advantages described above. The current limiting circuit may clamp programming current directly, or may act to limit program current by affecting voltage drop between BL and SL, or the ZCL ramping voltage, according to sensed programming current.

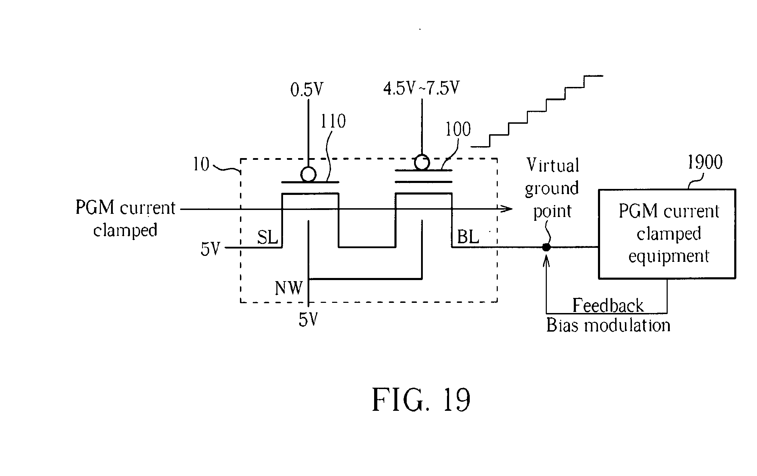

Please refer to FIG 19, which is a diagram of the memory cell 10 of FIG 1 electrically connected to a program current limiting circuit 1900. In FIG 19, the program current limiting circuit 1900 acts to control source-line-to-bit-line (SL-BL) bias by controlling voltage level of the bit line BL. As described above, the SL-BL bias may also be controlled by electrically connecting the program current limiting circuit 1900 to the source line SL instead of to the bit line BL. The program current limiting circuit 1900 is electrically connected to the bit line, and controls program current of the memory cell 10. As shown in FIG 19, ZCL ramping (e.g. 4.5V 7.5V) is applied to the gate of the memory transistor 100 as described above. The select transistor 110 is biased by a low voltage, e.g. 0.5V, at its gate, and a select line voltage, e.g. 5V at the select line input. The wells of the memory transistor 100 and select transistor 110 are both tied to a well voltage common to the SL, e.g. 5V To limit the program current, the program current limiting circuit 1900 senses the program current, and uses feedback bias modulation to establish a virtual ground point at the bit line. Actual voltage at the bit line may change as Vt of the memory transistor 100 changes during programmed, as described above. In some embodiments, the program current limiting circuit 1900 may be electrically connected to the source line of the select transistor 110. In some embodiments, a program current limiting circuit such as the program current limiting circuit 1900 may be electrically connected at each of the current ends of the memory cell 10, i.e. at the bit line and the source line.

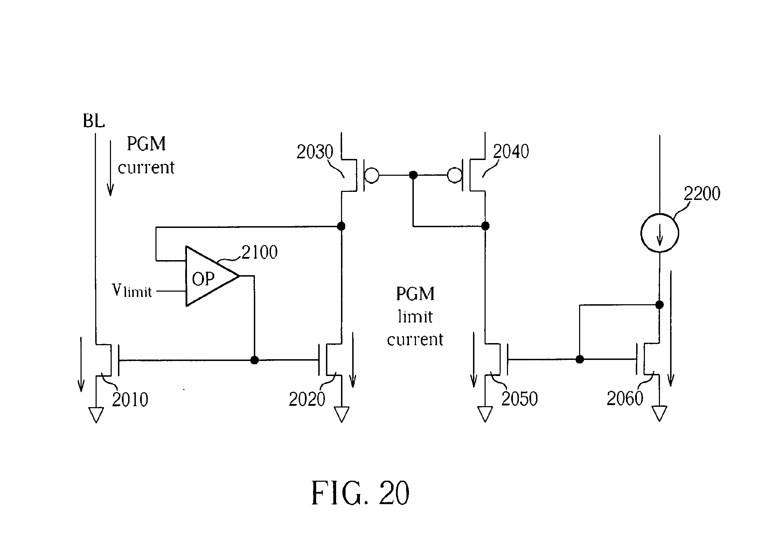

Many different program current limiting circuits are available as candidates for the program current limiting circuit 1900. Please refer to FIG 20, which is a diagram of one configuration of the program current limiting circuit 1900 of FIG 19. The program current limiting circuit 1900 shown in FIG 20 is only one example. The program current limiting circuit 1900 comprises a first transistor 2010, a second transistor 2020, a third transistor 2030, a fourth transistor 2040, a fifth transistor 2050, and a sixth transistor 2060. The first transistor 2010 receives the program current through electrical connection to the bit line. As shown, drain electrodes of the second transistor 2020 and the third transistor 2030 are electrically connected to each other, and drain electrodes of the fourth transistor 2040 and the fifth transistor 2050 are electrically connected to each other. The sixth transistor 2060 is diode-connected (gate electrode directly coupled to drain electrode), and receives a reference current from a reference current source 2200 at its drain electrode, which sets a program limit current value. Gate electrodes of the first transistor 2010 and the second transistor 2020 are electrically connected to each other, gate electrodes of the third transistor 2030 and the fourth transistor 2040 are electrically connected to each other, and gate electrodes of the fifth transistor 2050 and the sixth transistor 2060 are electrically connected to each other. The fourth transistor 2040 is diode-connected. The gate of the second transistor 2020 is controlled by an operational amplifier 2100. The operational amplifier 2100 receives a limit voltage Vlimit at a first input terminal, and outputs a feedback signal to the gate electrode of the second transistor 2020 to maintain the limit voltage Vlimit at the drain electrodes of the second transistor 2020 and the third transistor 2030, thereby stabilizing the BL (drain of the first transistor 2010) while programming. The reference current source 2200 effectively limits the program current, which flows through the first transistor 2010.

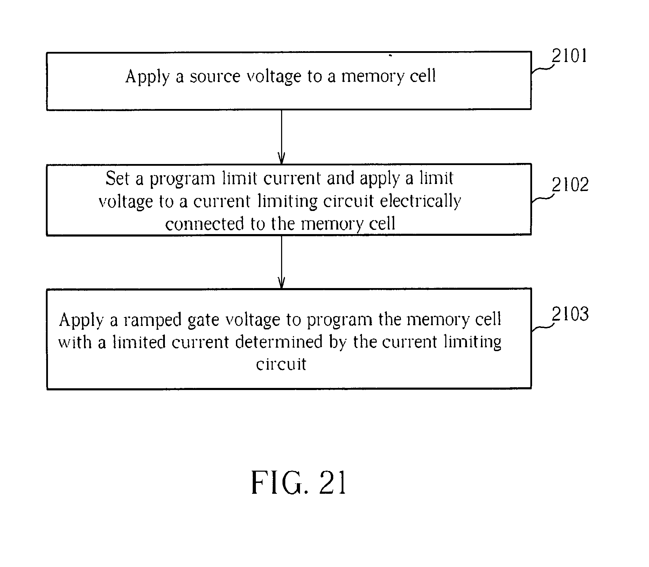

Please refer to FIG 21, which is a flowchart of a method for programming a memory cell, such as the memory cell 10. The method comprises the following steps:
Step 2101: Apply a source voltage to the memory cell;
Step 2102: Set a program limit current, and apply a limit voltage to a current limiting circuit electrically connected to the memory cell; and
Step 2103: Apply a ramped gate voltage to the memory cell to program the memory cell with a limited current determined by the current limiting circuit.

The source voltage is applied to the memory cell 10 at the source line SL (step 2101), which sets up a voltage drop from the source line SL to the bit line BL. The program limit current is set at the reference current source 2200 to clamp the program current of the memory cell 10. The limit voltage Vlimit is applied to the first input terminal of the operational amplifier 2100 (step 2102). To program the memory transistor 100, the ramped gate voltage (ZCL ramping) is applied to the gate of the memory transistor 100, and programming current of the memory cell 10 is limited by the current limiting circuit 1900 based on the program limit current and the limit voltage Vlimit (step 2103). In the current limiting circuit 1900 shown in FIG 20, the programming current of the memory cell 10 is limited by the reference current set by the reference current source 2200 flowing through the sixth transistor 2060. In some embodiments, the source voltage in step 2101 may be replaced with the bit line voltage, assuming the current limiting circuit 1900 is electrically connected to the source line instead of to the bit line.

Thus, by limiting the program current while using the ZCL ramping to program the memory cell, pumping circuit area does not need to be increased, less circuit area is wasted for program current prediction, and less damage is done to the memory cell, while maintaining good operation window.

## Claims

1. A method of programming a nonvolatile memory cell (10) in accordance with claim 6, the method comprising:
applying a bias voltage to a first input of a memory cell (10) which comprises the select transistor (110) and the memory transistor (100);
and further **characterized by**:
applying a preset limit current (2200) to the first transistor (2060) of the current limiting circuit (1900) and applying a program current to the second transistor (2010) of the current limiting circuit (1900), wherein the current limiting circuit (1900) is electrically connected to a second input of the memory cell (10) and includes the operational amplifier (2100) which receives a voltage limit input and provides a feedback signal to the third transistor (2020) of the current limiting circuit (1900) to stabilize a bit line voltage of the second transistor (2010); and
applying a ramped gate voltage to the memory cell (10) to program the memory cell (10) with the preset limited current (2200) determined by the current limiting circuit (1900).

2. The method of claim 1, further **characterized by** applying the bias voltage to the first input when the first input is a source line, and applying the preset limit current (2200) to the current limiting circuit (1900) electrically connected to the second input when the second input is a bit line.

3. The method of claim 1 further **characterized by** applying the bias voltage to the first input when the first input is a bit line, and applying the preset limit current (2200) to the current limiting circuit (1900) electrically connected to the second input when the second input is a source line.

4. The method of claim 1 **characterized in that** providing the feedback signal to the transistor (2020) of the current limiting circuit (1900) to stabilize the bit line voltage of the second transistor (2010) controls source-line-to-bit-line bias of the memory cell (10).

5. The method of claim 4, **characterized in that** controlling source-line-to-bit-line bias of the memory cell (10) establishes a virtual ground point which is stabilized by the preset limit current (2200).

6. A nonvolatile memory device (10) comprising:
a select transistor (110) having a first terminal, a second terminal and a gate terminal;
a memory transistor (100) having a third terminal coupled to the second terminal of the select transistor (110), a fourth terminal and a control terminal receiving a ramped gate voltage for inducing a program current having a preset limited current to program the memory transistor (100);
a current limiting circuit (1900) for controlling a voltage drop across the first terminal of the select transistor (110) and the fourth terminal of the memory transistor (100) for limiting the program current, the current limiting circuit (1900) comprising:
a first transistor (2060) for receiving a preset limit current (2200) of the current limiting circuit (1900);
a second transistor (2010) for receiving the program current and having its current path coupled between the memory transistor (100) and a reference potential; and
a current mirror (2060, 2050, 2040, 2030) for generating a representation of the preset limit current (2200);
**characterized in that** the current limiting circuit (1900) further comprises:
a third transistor (2020) coupled between the output of the current mirror (2060, 2050, 2040, 2030) and a reference potential;
the second transistor (2010) having its control gate connected to the control gate of the third transistor (2020); and
an operational amplifier (2100) having one input connected to a voltage limit node (Vlimit), having a second input connected to a node formed between the output of the current mirror (2060, 2050, 2040, 2030) and the third transistor (2020), and having an output connected to the control gates of the second (2010) and third (2020) transistors.

7. The nonvolatile memory device (10) of claim 6 further **characterized in that** the current limiting circuit (1900) is electrically connected to the first terminal of the select transistor (110).

8. The nonvolatile memory device (10) of claim 6 further **characterized in that** the current limiting circuit (1900) is electrically connected to the fourth terminal of the memory transistor (100).

9. The nonvolatile memory device (10) of claim 6 further **characterized in that** the second transistor (2010) is an input terminal for sensing the program current, and the first transistor (2060) is an output terminal for controlling the voltage drop according to the sensed program current.

10. The nonvolatile memory device (10) of claim 9 further **characterized in that** the output terminal of the current limiting circuit (1900) is electrically connected to the fourth terminal of the memory transistor (100).

11. The nonvolatile memory device of claim 9 further **characterized in that** the output terminal of the current limiting circuit (1900) is electrically connected to the first terminal of the select transistor (110).

## Patentansprüche

1. Verfahren zum Programmieren einer nichtflüchtigen Speicherzelle (10) gemäß Anspruch 6, wobei das Verfahren umfasst:
Anlegen einer Vorspannung auf eine erste Eingabe einer Speicherzelle (10), die den Auswahltransistor (110) und den Speichertransistor (100) umfasst,
ferner **gekennzeichnet durch**:
Anlegen eines vorbestimmten Begrenzungsstroms (2200) auf den ersten Transistor (2060) der Strombegrenzungsschaltung (1900) und Anlegen eines Programmstroms an den zweiten Transistor (2010) der Strombegrenzungsschaltung (1900), wobei die Strombegrenzungsschaltung (1900) mit einer zweiten Eingabe der Speicherzelle (10) elektrisch verbunden ist und den Operationsverstärker (2100) beinhaltet, der eine Spannungsbegrenzungseingabe erhält und ein Feedbacksignal an den dritten Transistor (2020) der Strombegrenzungsschaltung (1900) bereitstellt, um eine Bitleitungsspannung des zweiten Transistors (2010) zu stabilisieren; und
Anlegen einer ansteigenden Gate-Spannung auf die Speicherzelle (10), um die Speicherzelle (10) mit dem vorbestimmten Begrenzungsstrom (2200), der **durch** die Strombegrenzungsschaltung (1900) bestimmt wird, zu programmieren.

2. Verfahren nach Anspruch 1, ferner **gekennzeichnet durch** Anlegen der Vorspannung auf die erste Eingabe, wenn die erste Eingabe eine Quellenleitung ist, sowie Anlegen des vorbestimmten Begrenzungsstroms (2200) auf die Strombegrenzungsschaltung (1900), die mit der zweiten Eingabe elektrisch verbunden ist, wenn die zweite Eingabe eine Bitleitung ist.

3. Verfahren nach Anspruch 1, ferner **gekennzeichnet durch** Anlegen der Vorspannung auf die erste Eingabe, wenn die erste Eingabe eine Bitleitung ist, und Anlegen des vorbestimmten Begrenzungsstroms (2200) auf die Strombegrenzungsschaltung (1900), die mit der zweiten Eingabe elektrisch verbunden ist, wenn die zweite Eingabe eine Quellenleitung ist.

4. Verfahren nach Anspruch 1, **dadurch gekennzeichnet, dass** das Bereitstellen des Feedbacksignals an den Transistor (2020) der Strombegrenzungsschaltung (1900), um die Bitleitungsspannung des zweiten Transistors (2010) zu stabilisieren, die Quellenleitung-zu-Bitleitung-Vorspannung der Speicherzelle (10) steuert.

5. Verfahren nach Anspruch 4, **dadurch gekennzeichnet, dass** das Steuern der Quellenleitung-zu-Bitleitung-Vorspannung der Speicherzelle (10) einen virtuellen Massepunkt etabliert, der durch den vorbestimmten Begrenzungsstrom (2200) stabilisiert wird.

6. Nichtflüchtige Speichervorrichtung (10) umfassend:
einen Auswahltransistor (110) mit einem ersten Anschluss, einem zweiten Anschluss und einem Gate-Anschluss.
einen Speichertransistor (100) mit einem dritten Anschluss, der mit dem zweiten Anschluss des Auswahltransistors (110) verbunden ist, einem vierten Anschluss und einem Steueranschluss, der eine ansteigende Gate-Spannung zum Induzieren eines Programmstroms mit einem vorbestimmten Begrenzungsstrom erhält, um den Speichertransistor (100) zu programmieren,
eine Strombegrenzungsschaltung (1900) zum Steuern eines Spannungsabfalls über dem ersten Anschluss des Auswahltransistors (110) und dem vierten Anschluss des Speichertransistors (100) zum Begrenzen des Programmstroms, wobei die Strombegrenzungsschaltung (1900) umfasst:
einen ersten Transistor (2060) zum Erhalten eines vorbestimmten Begrenzungsstroms (2200) der Strombegrenzungsschaltung (1900);
einen zweiten Transistor (2010) zum Erhalten des Programmstroms, wobei der Strompfad des zweiten Transistors zwischen dem Speichertransistor (100) und einem Bezugspotential gekoppelt vorliegt, und
einen Stromspiegel (2060, 2050. 2040, 2030) zum Erzeugen einer Repräsentanz des vorbestimmten Begrenzungsstroms (2200);
**dadurch gekennzeichnet, dass** die Strombegrenzungsschaltung (1900) ferner umfasst:
einen dritte Transistor (2020), der zwischen der Ausgabe des Stromspiegels (2060, 2050, 2040, 2030) und einem Referenzpotential gekoppelt vorliegt,
wobei das Steuer-Gate des zweiten Transistors (2010) mit dem Steuer-Gate des dritten Transistors (2020) verbunden ist, und
einen Operationsverstärker (2100) mit einer Eingabe, die mit einem Spannungsbegrenzungsknoten (Vlimit) verbunden ist, wobei eine zweite Eingabe mit einem Knoten verbunden ist, der zwischen der Ausgabe des Stromspiegels (2060, 2050, 2040, 2030) und dem dritten Transistor (2020) verbunden ist, und wobei eine Ausgabe mit den Steuer-Gates des zweiten (2010) und des dritten (2020) Transistors verbunden ist.

7. Nichtflüchtige Speichervorrichtung (10) nach Anspruch 6, ferner **dadurch gekennzeichnet, dass** die Strombegrenzungsschaltung (1900) mit dem ersten Anschluss des Auswahltransistors (110) elektrisch verbunden ist.

8. Nichtflüchtige Speichervorrichtung (10) nach Anspruch 6, ferner **dadurch gekennzeichnet, dass** die Strombegrenzungsschaltung (1900) mit dem vierten Anschluss des Speichertransistors (100) elektrisch verbunden ist.

9. Nichtflüchtige Speichervorrichtung (10) nach Anspruch 6. ferner **dadurch gekennzeichnet, dass** der zweite Transistor (2010) ein Eingabeanschluss zum Erfassen des Programmstroms ist, und dass der erste Transistor (2060) ein Ausgabeanschluss zum Steuern des Spannungsabfalls über dem erfassten Programmstrom ist.

10. Nichtflüchtige Speichervorrichtung (10) nach Anspruch 9, ferner **dadurch gekennzeichnet, dass** der Ausgabeanschluss der Strombegrenzungsschaltung (1900) mit dem vierten Anschluss des Speichertransistors (100) elektrisch verbunden ist.

11. Nichtflüchtige Speichervorrichtung nach Anspruch 9, ferner **dadurch gekennzeichnet, dass** der Ausgabeanschluss der Strombegrenzungsschaltung (1900) mit dem ersten Anschluss des Auswahltransistors (110) elektrisch verbunden ist.

## Revendications

1. Procédé de programmation d'une cellule de mémoire non volatile (10) selon la revendication 6, le procédé comprenant :
l'application d'une tension de polarisation à une première entrée d'une cellule de mémoire (10) qui comprend le transistor de sélection (110) et le transistor de mémoire (100) ;
et **caractérisé en outre par** :
l'application d'un courant limite prédéfini (2200) au premier transistor (2060) du circuit limiteur de courant (1900) et l'application d'un courant de programme au deuxième transistor (2010) du circuit limiteur de courant (1900), dans lequel le circuit limiteur de courant (1900) est connecté électriquement à une seconde entrée de la cellule de mémoire (10) et comprend l'amplificateur opérationnel (2100) qui reçoit une entrée de limite de tension et fournit un signal de rétroaction au troisième transistor (2020) du circuit limiteur de courant (1900) pour stabiliser une tension de ligne de bits du deuxième transistor (2010) ; et
l'application d'une tension de grille progressive à la cellule de mémoire (10) pour programmer la cellule de mémoire (10) avec le courant limité prédéfini (2200) déterminé par le circuit limiteur de courant (1900).

2. Procédé selon la revendication 1, **caractérisé en outre par** l'application de la tension de polarisation à la première entrée lorsque la première entrée est une ligne de source, et l'application du courant limite prédéfini (2200) au circuit limiteur de courant (1900) connecté électriquement à la seconde entrée lorsque la seconde entrée est une ligne de bits.

3. Procédé selon la revendication 1, **caractérisé en outre par** l'application de la tension de polarisation à la première entrée lorsque la première entrée est une ligne de bits, et l'application du courant limite prédéfini (2200) au circuit limiteur de courant (1900) connecté électriquement à la seconde entrée lorsque la seconde entrée est une ligne de source.

4. Procédé selon la revendication 1, **caractérisé en ce que** la fourniture du signal de rétroaction au transistor (2020) du circuit limiteur de courant (1900) pour stabiliser la tension de ligne de bits du deuxième transistor (2010) commande la polarisation de ligne de source à ligne de bits de la cellule de mémoire (10).

5. Procédé selon la revendication 4, **caractérisé en ce que** la commande de la polarisation de ligne de source à ligne de bits de la cellule de mémoire (10) établit un point de terre virtuel qui est stabilisé par le courant limite prédéfini (2200).

6. Dispositif de mémoire non volatile (10) comprenant :
un transistor de sélection (110) possédant une première borne, une deuxième borne et une borne de grille ;
un transistor de mémoire (100) possédant une troisième borne couplée à la deuxième borne du transistor de sélection (110), une quatrième borne et une borne de commande recevant une tension de grille progressive pour induire un courant de programme possédant un courant limité prédéfini pour programmer le transistor de mémoire (100) ;
un circuit limiteur de courant (1900) pour commander une chute de tension à travers la première borne du transistor de sélection (110) et la quatrième borne du transistor de mémoire (100) pour limiter le courant de programme, le circuit limiteur de courant (1900) comprenant :
un premier transistor (2060) destiné à recevoir un courant limite prédéfini (2200) du circuit limiteur de courant (1900) ;
un deuxième transistor (2010) destiné à recevoir le courant de programme et
dont la trajectoire de courant est couplée entre le transistor de mémoire (100) et
un potentiel de référence ; et
un miroir de courant (2060, 2050, 2040, 2030) destiné à générer une représentation du courant limite prédéfini (2200) ;
**caractérisé en ce que** le circuit limiteur de courant (1900) comprend en outre :
un troisième transistor (2020) couplé entre la sortie du miroir de courant (2060, 2050, 2040, 2030) et un potentiel de référence ;
le deuxième transistor (2010) dont la grille de commande est connectée à la grille de commande du troisième transistor (2020) ; et
un amplificateur opérationnel (2100) dont une entrée est connectée à un noeud limite de tension (Vlimit), dont une deuxième entrée est connectée à un noeud formé entre la sortie du miroir de courant (2060, 2050, 2040, 2030) et le troisième transistor (2020), et dont une sortie est connectée aux grilles de commande des deuxième (2010) et troisième (2020) transistors.

7. Dispositif de mémoire non volatile (10) selon la revendication 6, **caractérisé en outre en ce que** le circuit limiteur de courant (1900) est connecté électriquement à la première borne du transistor de sélection (110).

8. Dispositif de mémoire non volatile (10) selon la revendication 6, **caractérisé en outre en ce que** le circuit limiteur de courant (1900) est connecté électriquement à la quatrième borne du transistor de mémoire (100).

9. Dispositif de mémoire non volatile (10) selon la revendication 6, **caractérisé en outre en ce que** le deuxième transistor (2010) est une borne d'entrée destinée à détecter le courant de programme, et le premier transistor (2060) est une borne de sortie destinée à commander la chute de tension selon le courant de programme détecté.

10. Dispositif de mémoire non volatile (10) selon la revendication 9, **caractérisé en outre en ce que** la borne de sortie du circuit limiteur de courant (1900) est connectée électriquement à la quatrième borne du transistor de mémoire (100).

11. Dispositif de mémoire non volatile selon la revendication 9, **caractérisé en outre en ce que** la borne de sortie du circuit limiteur de courant (1900) est connectée électriquement à la première borne du transistor de sélection (110).
